# FASCICULE DE BREVET EUROPEEN

(11) **EP 1 315 295 B1**
(45) Date de publication et mention de la délivrance du brevet: **23.05.2007**
(21) Numéro de dépôt: 02079813.8
(22) Date de dépôt: 20.11.2002
(51) Int. Cl.: H03H 7/01

(54) **Tuner comprenant un filtre sélectif**
Tuner mit einem Selektivfilter
Tuner comprising a selective filter

(30) Priorité: 27.11.2001 FR 0115312
(43) Date de publication de la demande: 28.05.2003
(73) Titulaire: Koninklijke Philips Electronics N.V., 5621 BA Eindhoven (NL)
(72) Inventeur: Amiot, Sébastien, 75008 Paris (FR); Paris, Jean-Marc, 75008 Paris (FR); Zaid, Lakhdar, 75008 Paris (FR)
(74) Mandataire: White, Andrew Gordon

(56) Documents cités:
- EP-A- 0 176 069
- EP-A- 0 427 928
- US-A- 4 244 008
- US-B1- 6 208 482
- US-B1- 6 252 457
- US-B1- 6 285 865
- PATENT ABSTRACTS OF JAPAN vol. 2000, no. 12, 3 janvier 2001 (2001-01-03) & JP 2000 252766 A (FUJITSU QUANTUM DEVICE KK), 14 septembre 2000 (2000-09-14)

## Description

### DOMAINE DE L'INVENTION

L'invention concerne un tuner pour convertir un signal radio-fréquence (RF) en un signal de sortie de fréquence intermédiaire (IF), ledit tuner comprenant un mélangeur pour générer un premier signal de fréquence intermédiaire, des moyens de traitement pour filtrer ledit premier signal de fréquence intermédiaire afin de générer ledit signal de sortie de fréquence intermédiaire.
L'invention a de nombreuses applications dans les systèmes de réception de signaux radio-fréquence.

### ARRIERE PLAN TECHNOLOGIQUE DE L'INVENTION

Un tuner a pour rôle de sélectionner dans un signal radio-fréquence d'entrée un signal de données centré sur une certaine fréquence, et de convertir le signal sélectionné en un signal de sortie de fréquence intermédiaire. Le signal de données définit un canal de fréquences. Un tuner est couramment utilisé dans des appareils de type radio, téléviseur, ou plus généralement dans des appareils traitant des signaux d'entrée modulés qui véhiculent des données multimédias.

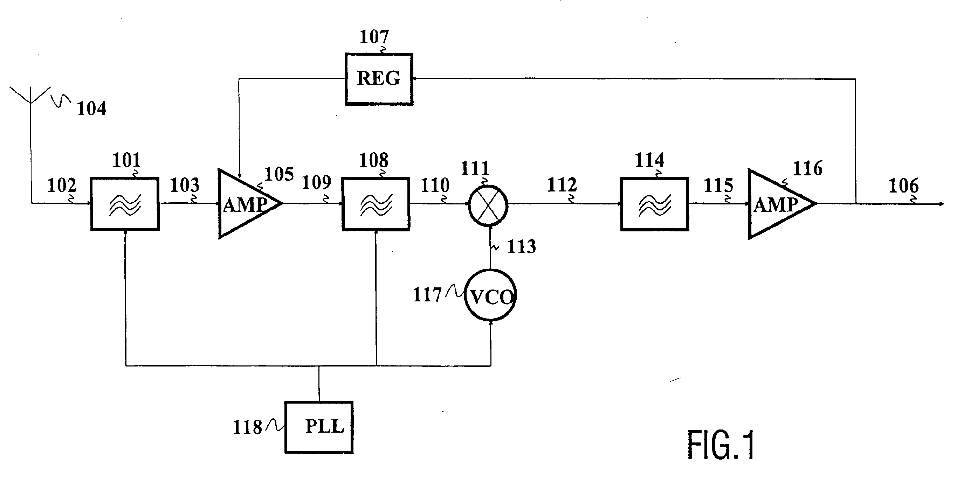

La figure 1 décrit les différents blocs fonctionnels d'un tuner de type connu de l'art antérieur.
Le tuner comprend des moyens de filtrage 101 recevant un signal radio-fréquence 102 et délivrant un premier signal filtré 103. Les moyens de filtrage 101 effectuent d'une part une adaptation d'impédance et de niveau avec les moyens de réception 104 (antenne, câble ...), et d'autre part effectuent un filtrage sélectif dans le spectre du signal 102 autour du spectre de fréquence du canal désiré. Le signal filtré 103 est amplifié par un amplificateur 105 de telle sorte que l'amplitude du signal de sortie 106 de fréquence intermédiaire reste constante quel que soit le niveau du signal de radio-fréquence 102. Pour cela, il est prévu des moyens de régulation 107 permettant le contrôle automatique du gain appliqué au signal filtré 103 par l'amplificateur 105. Les moyens de filtrage 108 effectuent un filtrage sur le signal amplifié 109 de façon à accentuer la sélectivité du canal désiré, pour générer un signal de sortie 110. En particulier, les moyens de filtrage 108 permettent de supprimer les fréquences images dans le spectre fréquentiel. Le tuner comprend également un mélangeur 111 pour effectuer la conversion du signal radio-fréquence d'entrée 110 en un signal de sortie de fréquence intermédiaire 112. Le mélangeur 111 reçoit le signal de sortie 113 généré par un oscillateur 117 commandé en tension. Le mélangeur 111 effectue une multiplication du signal d'entrée 110 avec ledit signal de sortie 113, entraînant sur le signal 110 un décalage fréquentiel. Le signal de fréquence intermédiaire 112, dont la fréquence est égale à la différence des fréquences des signaux 113 et 110, est filtré par les moyens de filtrage 114 pour atténuer les résidus de radio-fréquences, et générer un signal de fréquence intermédiaire filtré 115. En particulier, les moyens de filtrage 114 atténuent les fréquences résiduelles issues du mélangeur 111, ainsi que les fréquences résiduelles issues des canaux adjacents au canal désiré et qui n'ont pas été complètement supprimées par les moyens de filtrage 101 et 108.
Le signal de fréquence intermédiaire filtré 115 est ensuite amplifié au moyen de l'amplificateur 116 pour générer ledit signal de sortie de fréquence intermédiaire 106. Des moyens de contrôle 118 de type boucle à verrouillage de phase permettent de contrôler la fréquence centrale des moyens de filtrage 101 et 108, et assurent la stabilité de la phase du signal de fréquence intermédiaire 112 en délivrant à l'oscillateur 117 un signal de tension de niveau variable.

Le brevet des Etats Unis d'Amérique n° 6,070,061 décrit un tuner pour la conversion d'un signal radio-fréquence en un signal de fréquence intermédiaire. Ce brevet prévoit des moyens de filtrage sélectifs constitués par la mise en cascade de deux filtres sélectifs pour former un filtre passe-bande appliqué sur le signal de fréquence intermédiaire.

Ces moyens de filtrage sélectifs présentent un certain nombre de limitations, en particulier lorsque le spectre radio-fréquence comprend des canaux de fréquences rapprochés les uns des autres et dont les niveaux varient dans de larges rapports.

De par la diffusion massive de chaînes de télévision numériques, et considérant que l'étendue du spectre radio-fréquence est limitée, les canaux fréquentiels relatifs à chaque chaîne sont très rapprochés les uns des autres. Dans ce contexte, les moyens de filtrage décrits dans le document de l'art antérieur ne permettent pas une sélection précise d'un canal particulier. En effet, la sélectivité de ces moyens de filtrage n'est pas suffisamment élevée, d'une part parce que le lobe principal de la réponse fréquentielle n'est pas suffisamment prononcé, mais aussi parce que l'amplitude des lobes secondaires est élevée. Ainsi, des composantes fréquentielles des canaux adjacents ne sont pas supprimées par les moyens de filtrage. Cela conduit à un signal de fréquence intermédiaire de mauvaise qualité, donc à une mauvaise qualité d'image lorsqu'il s'agit d'un signal vidéo.
De plus, ces canaux numériques composant le spectre radio-fréquence sont couramment diffusés via une modulation numérique, par exemple du type QAM. Ce type de modulation autorise au tuner une très faible variation du gain (appelée "tilt" en anglais) sur l'étendue fréquentielle du canal à sélectionner. Typiquement, une variation maximale de 0.5 dB est autorisée pour un canal d'une largeur de 6 à 8 MHz. Les moyens de filtrage sélectifs décrits dans le document de l'art antérieur ne permettent pas de satisfaire aux exigences de ce type de modulation dans la mesure où ils présentent un tilt élevé sur un canal d'une largeur de 6 à 8 MHz, ce qui se traduit par une mauvaise réception du canal désiré et/ou une mauvaise qualité d'image lorsqu'il s'agit d'un signal vidéo.

### RESUME DE L'INVENTION

L'invention a pour but de proposer un tuner à sélectivité et linéarité améliorées pour effectuer la conversion d'un signal radio-fréquence en un signal de fréquence intermédiaire.

Pour cela, le tuner selon invention est remarquable en ce que lesdits moyens de traitement comprennent :
- un circuit suiveur de tension recevant ledit premier signal de fréquence intermédiaire pour générer à basse impédance un deuxième signal de fréquence intermédiaire,
- des moyens de régulation pour réguler la valeur du courant de polarisation dudit circuit suiveur de tension,
- un filtre à double fréquence de résonance pour filtrer ledit deuxième signal de fréquence intermédiaire et générer ledit signal de sortie de fréquence intermédiaire.

Le tuner selon l'invention comprend des moyens de traitement qui reposent sur l'utilisation d'un filtre à double fréquence de résonance permettant d'obtenir une forte sélectivité autour de la fréquence intermédiaire, typiquement de valeur d'environ 44 MHz. De cette façon, les résidus fréquentiels des canaux adjacents au canal sélectionné sont éliminés du spectre fréquentiel, et ce même si leur niveau est beaucoup plus élevé que le niveau du canal sélectionné. Le signal de sortie de fréquence intermédiaire est donc exempt de composante fréquentielle issue des canaux adjacents, ce qui conduit à une meilleure qualité de l'information contenue dans le canal sélectionné. L'utilisation d'un filtre à double fréquence de résonance permet, en plus de filtrer de façon sélective, de garantir une très faible variation du gain sur l'étendue fréquentielle du canal à sélectionner.
Le filtre à double fréquence de résonance est isolé du mélangeur par un circuit suiveur de tension présentant à sa sortie une basse impédance. Pour annuler les variations du courant traversant le circuit suiveur de tension provoquées par les variations d'impédance d'entrée du filtre à double fréquence de résonance lorsque la fréquence varie, des moyens de régulation sont associés au circuit suiveur de tension. De cette façon, le circuit suiveur de tension est toujours parcouru par un courant de polarisation de valeur constante, ce qui présente l'avantage d'assurer un régime de fonctionnement linéaire. Sur la largeur fréquentielle du canal sélectionné, les composantes fréquentielles ne subissent alors qu'une très faible atténuation relative, ce qui permet d'envisager l'utilisation d'un tel tuner pour des canaux modulés en numérique.
Le tuner selon l'invention présente aussi l'avantage d'être mis en oeuvre pour la conversion de signaux radio-fréquence comprenant des canaux modulés selon une technique analogique. En effet, dans ce cas, les canaux sont plus espacés et le tuner selon invention permet aussi la sélection d'un tel canal. Le tuner selon l'invention est donc d'utilisation mixte ce qui est avantageux lorsque les signaux radio-fréquence sont tantôt modulés selon une technique numérique, tantôt selon une technique analogique puisqu'un seul tuner suffit.

L'invention est aussi remarquable en ce que le filtre à double fréquence de résonance comprend deux circuits résonants connectés par des moyens de couplage.
Une telle implémentation du filtre à double fréquence de résonance présente l'avantage de pouvoir régler de façon précise la sélectivité d'ensemble du filtre. D'autre part, un tel circuit à couplage mutuel permet d'obtenir une réponse fréquentielle exempte de lobe secondaire qui pourrait introduire une mauvaise réjection des composantes fréquentielles issues des canaux adjacents.

L'invention est aussi remarquable en ce que lesdits moyens de couplage comprennent une liaison capacitive.
La mise en oeuvre d'une liaison capacitive dans le filtre à double fréquence de résonance conduit à une solution peu coûteuse.

L'invention concerne également un appareil de type boîtier de réception qui implémente un tuner ayant les caractéristiques décrites ci-dessus et qui permet la conversion d'un signal radio-fréquence en un signal de fréquence intermédiaire.

L'invention concerne également un appareil de télévision qui implémente un tuner ayant les caractéristiques décrites ci-dessus et qui permet la conversion d'un signal radio-fréquence en un signal de fréquence intermédiaire.

### BREVE DESCRIPTIONS DES DESSINS

Ces aspects de l'invention ainsi que d'autres aspects plus détaillés apparaîtront plus clairement grâce à la description suivante, faite en regard des dessins ci-annexés, le tout donné à titre d'exemple non limitatif, dans lesquels :
La figure 1 décrit les différents blocs fonctionnels d'un tuner de type connu de l'art antérieur,
La figure 2 décrit l'agencement des différents moyens de traitement selon l'invention pour filtrer un signal de fréquence intermédiaire,
La figure 3 décrit un premier mode de réalisation des moyens de traitement selon l'invention pour filtrer un signal de fréquence intermédiaire,
La figure 4 décrit un second mode de réalisation des moyens de traitement selon l'invention pour filtrer un signal de fréquence intermédiaire,
La figure 5 décrit un mode de réalisation des moyens de régulation selon l'invention,
La figure 6 représente la réponse fréquentielle d'un filtre à double fréquence de résonance selon l'invention,
La figure 7 représente les variations de l'impédance d'entrée du filtre à double fréquence de résonance selon l'invention,
La figure 8 illustre une utilisation d'un tuner selon l'invention.

### DESCRIPTION DE MODES DE REALISATION DE L'INVENTION

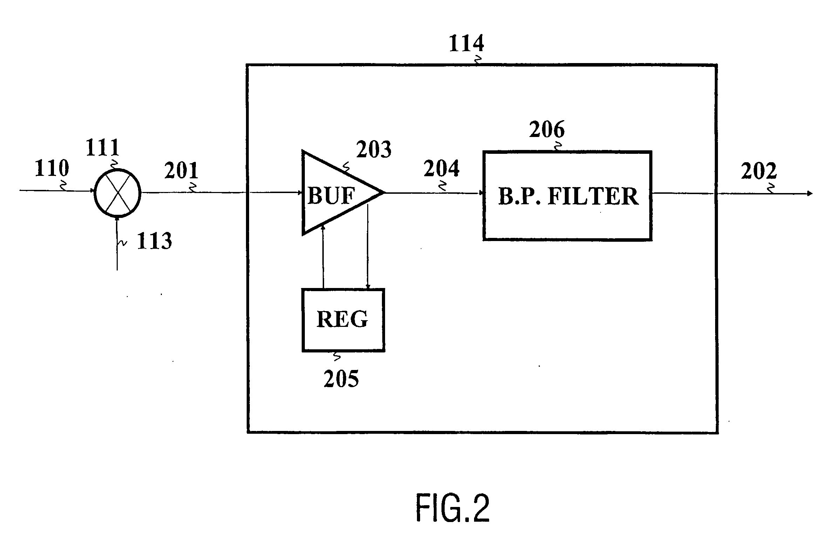

La figure 2 décrit l'agencement des différents moyens de traitement 114 selon l'invention pour filtrer un premier signal de fréquence intermédiaire 201, et délivrer un deuxième signal de sortie de fréquence intermédiaire 202.
Les moyens de traitement 114 reçoivent le premier signal de fréquence intermédiaire 201 généré par le mélangeur 111 tel que décrit à la figure 1. Dans un premier temps, un circuit suiveur de tension 203 reçoit le signal de fréquence intermédiaire 201 et délivre un deuxième signal de fréquence intermédiaire 204 à basse impédance. Des moyens de régulation 205, associés au dit circuit 203, permettent de réguler le courant de polarisation du circuit suiveur de tension de façon à garantir un fonctionnement en régime linéaire des éléments constituant ledit circuit. Dans un second temps, ledit deuxième signal de fréquence intermédiaire 204 est filtré au moyen d'un filtre à double fréquence de résonance 206 générant ledit signal de sortie de fréquence intermédiaire 202. De par ses caractéristiques sélectives, le filtre 206 permet d'éliminer dans le signal 204 les composantes fréquentielles résiduelles provenant des canaux adjacents au canal de fréquence sélectionné.

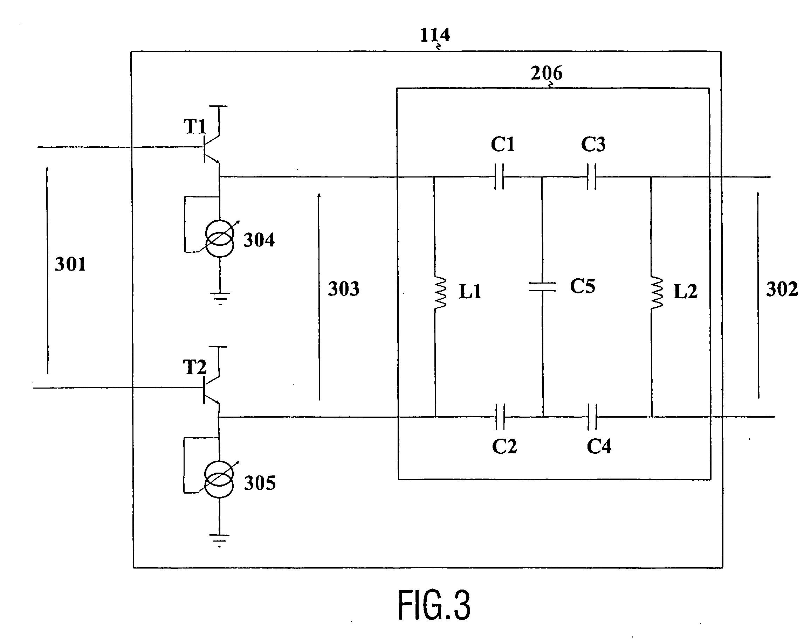

La figure 3 décrit un premier mode de réalisation des moyens de traitement selon l'invention pour filtrer un premier signal de fréquence intermédiaire 301, et délivrer un deuxième signal de sortie de fréquence intermédiaire 302.
Dans la mesure où le signal 301 est un signal différentiel sans référence à un potentiel particulier, l'entrée du circuit suiveur de tension est constituée par les bases des deux transistors T1 et T2. Les transistors T1 et T2 sont montés en émetteur suiveur de tension pour délivrer via leurs émetteurs un signal différentiel 303 à basse impédance. Les émetteurs des transistors T1 et T2 sont connectés aux sources de courant variable 304 et 305 qui permettent de débiter un courant d'émetteur de valeur constante quelles que soient les variations de l'impédance d'entrée du filtre à double fréquence de résonance 206 recevant ledit signal différentiel 303. Pour assurer cette régulation en courant, les sources de courant 304 et 305 sont associées à des moyens de régulation décrits par la suite.
Le filtre à double fréquence de résonance 206 est constitué d'un premier et d'un deuxième circuit résonant communiquant via un couplage capacitif.
Le premier circuit résonant est constitué des capacités C1-C2 et de l'inductance L1. Ces éléments définissent une première fréquence de résonance f1 dont la valeur dépend aussi des caractéristiques du deuxième circuit résonant.
Le deuxième circuit résonant est constitué des capacités C3-C4 et de l'inductance L2. Ces éléments définissent une deuxième fréquence de résonance f2 dont la valeur dépend aussi des caractéristiques du premier circuit résonant.

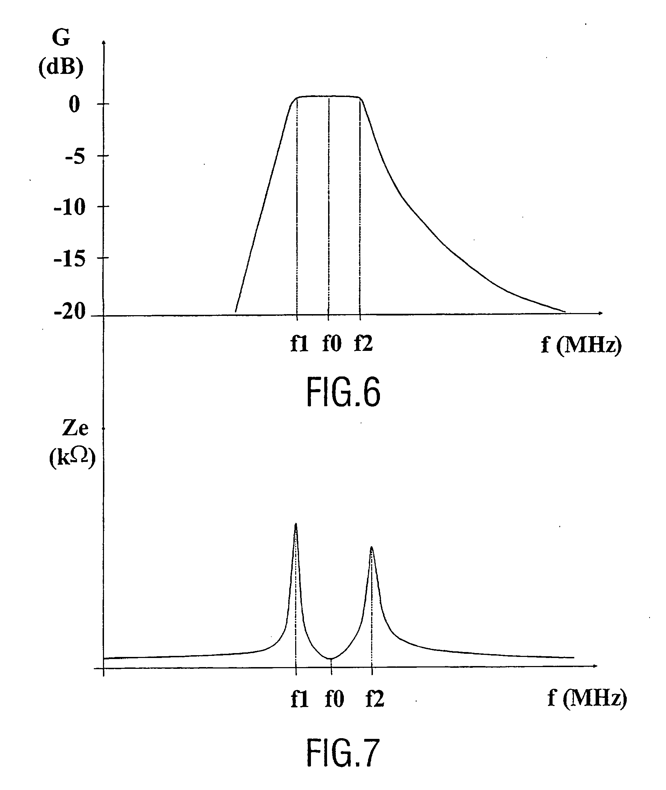

Le couplage entre les deux circuits résonants est effectué au moyen de la capacité C5. Un réglage des fréquences f1 et f2 par l'homme du métier permet d'obtenir une réponse fréquentielle du filtre à double fréquence de résonance telle celle illustrée par la figure 6. Cette réponse fréquentielle se caractérise en particulier par une zone de très faible variation de gain G autour de la fréquence intermédiaire f0, en particulier sur l'intervalle de fréquence [f1, f2], ce qui est dû à l'interaction mutuelle desdits premier et deuxième circuits résonants. En outre, la réponse fréquentielle en dehors de cette zone centrale est rapidement atténuée, démontrant le caractère fortement sélectif d'un tel filtre.
Pour obtenir une réponse fréquentielle telle que celle de la figure 6, l'homme du métier pourra fixer les valeurs des composants d'un des circuits résonants et faire varier les valeurs des composants de l'autre circuit jusqu'à obtenir une réponse fréquentielle uniforme autour de la fréquence f0.

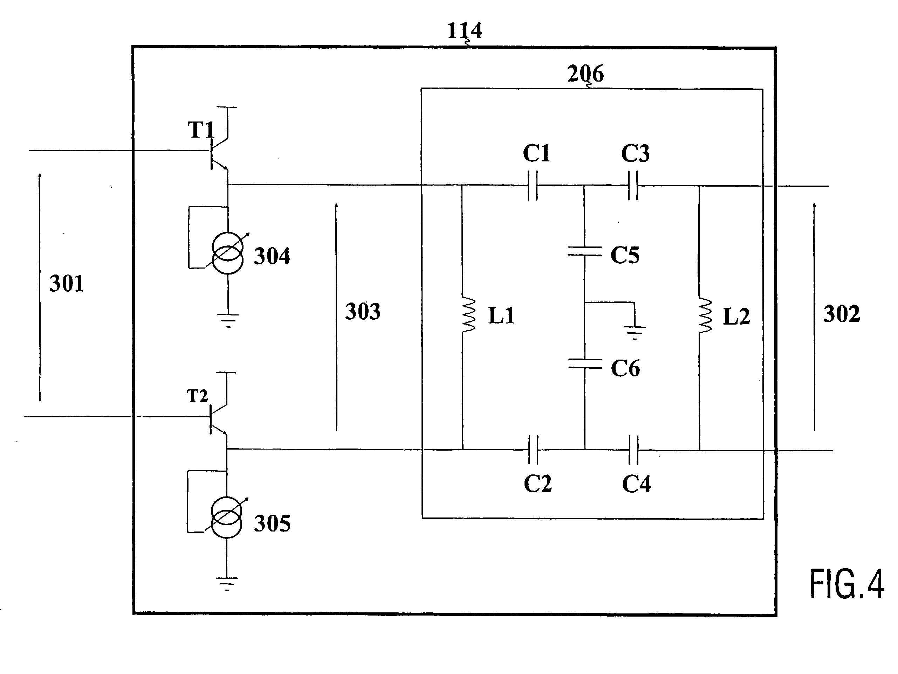

La figure 4 décrit un second mode de réalisation des moyens de traitement selon l'invention pour filtrer un premier signal de fréquence intermédiaire 301, et délivrer un deuxième signal de sortie de fréquence intermédiaire 302.
Ce mode de réalisation diffère de celui présenté à la figure 3 en ce que le couplage capacitif desdits premier et deuxième circuits résonants est constitué par la mise en série des condensateurs C5-C6, et dont le point milieu est mis à la masse. Cette configuration du couplage capacitif permet d'améliorer la réjection de mode commun du signal 303 à filtrer.

Comme mentionné précédemment, le circuit suiveur de tension est associé à des moyens de régulation pour maintenir le courant de polarisation dans les éléments constituant ledit circuit à une valeur constante. Comme illustré à la figure 7, l'impédance d'entrée Ze du filtre à double fréquence de résonance 206 présente une variation importante sur l'intervalle de fréquence [f1, f2], c'est-à-dire dans la zone sélective du filtre. En effet, l'impédance d'entrée du filtre prend des valeurs faibles pour des fréquences qui se situent autour de la fréquence intermédiaire f0, et des valeurs fortes pour des fréquences qui se situent aux extrémités de l'intervalle de fréquences [f1, f2]. En particulier, l'impédance Ze présente un minimum pour la fréquence fo, et des maximums pour les fréquences f1 et f2. Par conséquent, pour un même niveau dudit premier signal de fréquence intermédiaire 301, le courant Iout absorbé par le filtre à double fréquence de résonance varie également fortement sur l'intervalle de fréquence [f1, f2]. Le courant d'entrée Iout du filtre étant délivré par le circuit suiveur de tension constitué en particulier par les transistors T1 et T2, pour éviter que ces variations du courant Iout n'entraînent des variations du courant d'émetteur (et par conséquence du courant de base) dans les transistors T1 et T2, les moyens de régulation sont associés aux transistors T1 et T2 de façon à ce que le courant d'émetteur IE des transistors T1 et T2 garde une valeur constante quelles que soient les variations du courant Iout.

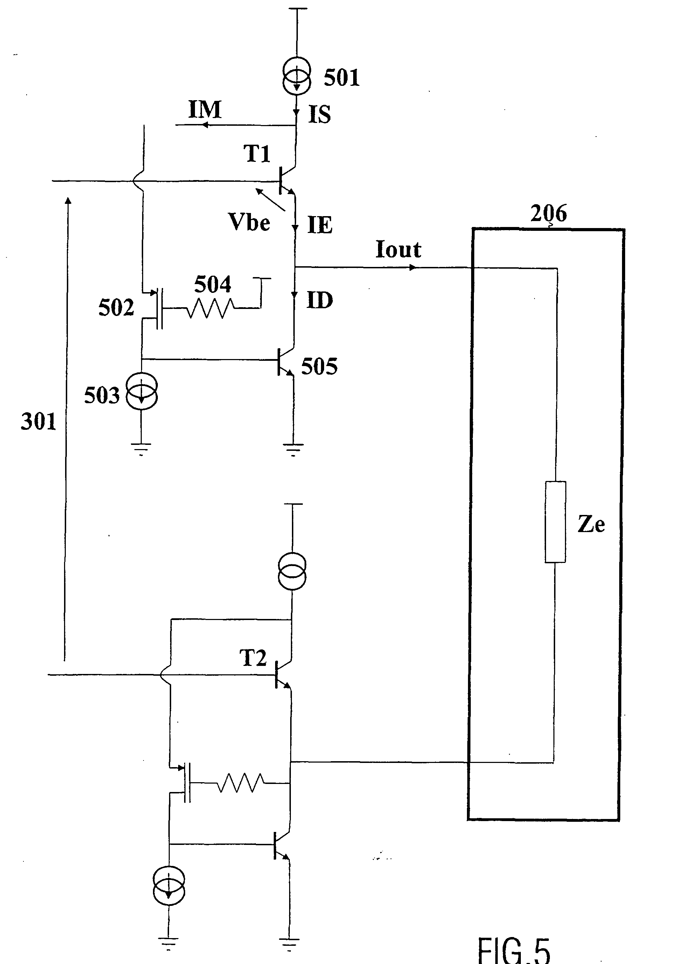

La figure 5 décrit un mode de réalisation desdits moyens de régulation selon l'invention. Le premier signal de fréquence intermédiaire 301 étant un signal différentiel, des moyens de régulation identiques sont associés au transistor T1 et au transistor T2. Seuls seront décrits les moyens de régulation associés au transistor T1.
Les moyens de régulation sont composés d'une source de courant 501 de valeur constante IS, du transistor 502, de la source de courant 503, de la résistance 504 et du transistor 505. Lorsque le courant Iout augmente, cela a tendance à entraîner une augmentation du courant IE, ce qui a tendance à entraîner une diminution du courant IM dans la mesure où le courant IS est constant. Via les éléments 502-503, cette diminution du courant IM entraîne une diminution du courant ID, ramenant ainsi IE à sa valeur constante d'équilibre. Cette régulation permet donc, en faisant varier le courant ID, de maintenir la somme des courants IE = (Iout + ID) a une valeur constante. Ainsi, le courant de base du transistor T1 garde également une valeur constante quelles que soient les variations du courant Iout, ce qui permet à T1 de présenter une résistance dynamique constante dans la jonction base-émetteur. En d'autres termes, la tension base-émetteur Vbe du transistor T1 reste constante.
De cette façon, le circuit suiveur de tension constitué du transistor T1, associé aux moyens de régulation décrits précédemment, permet d'obtenir un gain unitaire sur tout le spectre du canal de fréquence sélectionné.

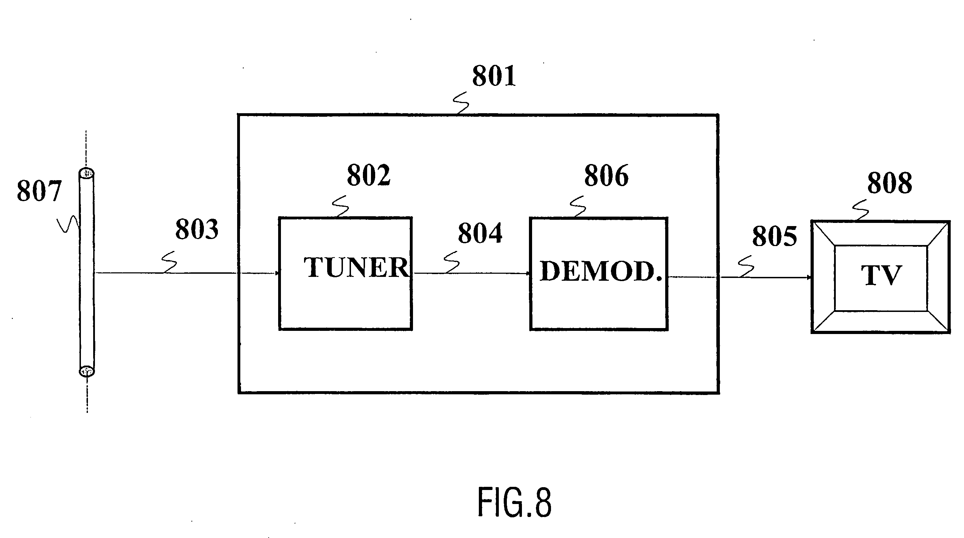

La figure 8 illustre un appareil 801 implémentant un tuner 802 tel que décrit à la figure 1 implémentant les caractéristiques selon l'invention telles que décrites aux figures 2-3-4-5. Cet appareil est dédié à la réception d'un signal radio-fréquence 803, à sa conversion en un signal de fréquence intermédiaire 804, et à la démodulation du signal 804 pour générer le signal de sortie démodulé 805 via les moyens de démodulation 806. Dans la mesure où le signal radio-fréquence 803 peut comporter à la fois des canaux modulés selon une technique analogique et des canaux modulés selon une technique numérique, le tuner 802 est de type hybride.
Par exemple, cet appareil 801 est de type boîtier de réception (en anglais "set-top box") dédié à la réception d'un signal vidéo radio-fréquence 803 transmis via un réseau câblé 807. Le signal de fréquence intermédiaire 804 délivré par le tuner selon l'invention est notamment par la suite amplifié et démodulé par les moyens de traitement 806, en vue d'une visualisation du contenu vidéo via des moyens de type écran 808.
Dans une autre utilisation, le tuner selon l'invention est directement intégré dans un poste de télévision.
D'un point de vue implémentation, les éléments du tuner selon l'invention tels que décrits à la figure 4 pourront être constitués par des composants de type « discrets », ou bien alors par des composants de type circuit intégré. En particulier, les éléments du circuit suiveur de tension régulé en courant peuvent être intégrés dans un circuit intégré.

Le tuner selon l'invention est particulièrement bien adapté au traitement de signaux radio-fréquence modulés selon une technique numérique de type QAM dans la mesure où il permet une sélection fine d'un canal de fréquence désiré, tout en rejetant les composantes fréquentielles des canaux adjacents. En particulier, ce type de tuner est adapté au traitement de signaux de radio-fréquence de type DVB diffusés par voie terrestre, mais aussi des signaux radio-fréquence modulés selon une technique analogique.
L'invention a été décrite dans le cadre d'un tuner simple conversion dans lequel un seul mélangeur est mis en oeuvre pour convertir un signal de radio-fréquence en un signal de fréquence intermédiaire. Bien sûr, l'invention peut également être utilisée dans des tuners à conversions multiples mettant en oeuvre plusieurs mélangeurs. Dans ce cas, il suffit de placer les moyens de traitement selon l'invention décrits à la figure 2 à la sortie du mélangeur délivrant un signal de fréquence intermédiaire.
Bien sûr, l'invention ne se limite pas aux seuls modes de réalisation présentés, et des alternatives pourraient être envisagées par l'homme du métier sans sortir du cadre de l'invention. En particulier, un autre type de régulation en courant du circuit suiveur de tension pourrait être envisagé (par exemple une régulation sans boucle de contre-réaction), ainsi que la mise en oeuvre d'une liaison inductive dans le filtre à double fréquence de résonance.

## Revendications

1. Tuner pour convertir un signal radio-fréquence en un signal de sortie de fréquence intermédiaire, ledit tuner comprenant un mélangeur (111) pour générer un premier signal de fréquence intermédiaire, des moyens de traitement (114) pour filtrer ledit premier signal de fréquence intermédiaire afin de générer ledit signal de sortie de fréquence intermédiaire, **caractérisé en ce que** lesdits moyens de traitement comprennent :
- un circuit suiveur de tension (T1,T2) recevant ledit premier signal de fréquence intermédiaire pour générer à basse impédance un deuxième signal de fréquence intermédiaire,
- des moyens de régulation (304,305) pour réguler la valeur du courant de polarisation dudit circuit 10 suiveur de tension,
- un filtre (206) à double fréquence de résonance pour filtrer ledit deuxième signal de fréquence intermédiaire et générer ledit signal de sortie de fréquence intermédiaire.

2. Tuner selon la revendication 1 **caractérisé en ce que** le filtre (206) à double fréquence de 15 résonance comprend deux circuits résonants (C1,C2,L1,C3,C4,L2) connectés par des moyens de couplage (C5).

3. Tuner selon la revendication 2 **caractérisé en ce que** lesdits moyens de couplage comprennent une liaison capacitive (C5).

4. Boîtier de réception pour recevoir et convertir un signal radio-fréquence en un signal de sortie de fréquence intermédiaire **caractérisé en ce qu'**il comprend un tuner selon la revendication 1.

5. Appareil de télévision **caractérisé en ce qu'**il comprend un tuner selon la revendication 1.

## Claims

1. Tuner for converting a radiofrequency signal into an intermediate-frequency output signal, said tuner comprising a mixer (111) for generating a first intermediate-frequency signal, processing means (114) for filtering said first intermediate-frequency signal in order to generate said intermediate-frequency output signal, **characterized in that** said processing means comprise:
- a voltage follower circuit (T1, T2) receiving said first intermediate-frequency signal to generate at low impedance a second intermediate-frequency signal;
- regulation means (304, 305) for regulating the value of the bias current of said voltage follower circuit; and
- a double resonance-frequency filter (206) for filtering said second intermediate-frequency signal and generating said intermediate-frequency output signal.

2. Tuner according to Claim 1, **characterized in that** the double resonance-frequency filter (206) comprises two resonant circuits (C1, C2, L1; C3, C4, L2) connected by coupling means (C5).

3. Tuner according to Claim 2, **characterized in that** said coupling means comprise a capacitive link (C5).

4. Set-top box for receiving and converting a radiofrequency signal into an intermediate-frequency output signal, **characterized in that** it comprises a tuner according to Claim 1.

5. Television appliance, **characterized in that** it comprises a tuner according to Claim 1.

## Patentansprüche

1. Tuner zur Umwandlung eines Radiofrequenzsignals in ein Zwischenfrequenzausgangssignal , wobei der Tuner einen Mischer (111) zur Erzeugung eines ersten Zwischenfrequenzsignals und Verarbeitungsmittel (114) zum Filtern des ersten Zwischenfrequenzsignals, um das Zwischenfrequenzausgangssignal zu erzeugen, umfasst, **dadurch gekennzeichnet, dass** die Verarbeitungsmittel folgendes umfassen :
- eine Spannungsfolgeschaltung (T1, T2), die das erste Zwischenfrequenzsignal aufnimmt, um bei niedriger Impedanz ein zweites Zwischenfrequenzsignal zu erzeugen,
- Regelmittel (304, 305), um den Wert des Polarisierungstroms der Spannungsfolgeschaltung zu regeln,
- einen Doppelfrequenz - Resonanzfilter (206), um das zweite Zwischenfrequenzsignal zu filtern und das Zwischenfrequenzausgangssignal zu erzeugen.

2. Tuner nach Anspruch 1, **dadurch gekennzeichnet, dass** der Doppelfrequenz - Resonanzfilter (206) zwei Schwingschaltungen (C1, C2 , L1 ; C3, C4 , L2) umfasst, die durch Kopplungsmittel (C5) verbunden sind.

3. Tuner nach Anspruch 2, **dadurch gekennzeichnet, dass** die Kopplungsmittel eine kapazitive Verbindung (C5) umfassen.

4. Empfänger zum Empfangen und Umwandeln eines Radiofrequenzsignals in ein Zwischenfrequenzausgangssignal **dadurch gekennzeichnet, dass** er einen Tuner nach Anspruch 1 umfasst.

5. Fernsehgerät **dadurch gekennzeichnet, dass** es einen Tuner nach Anspruch 1 umfasst.
